(19) **Europäisches Patentamt / European Patent Office / Office européen des brevets**

(11) **EP 4 170 363 B1**

(12) # FASCICULE DE BREVET EUROPEEN

(45) Date de publication et mention de la délivrance du brevet:
**11.06.2025 Bulletin 2025/24**

(21) Numéro de dépôt: **22199830.5**

(22) Date de dépôt: **05.10.2022**

(51) Classification Internationale des Brevets (IPC):
**G01R 31/12** *(2020.01)*

(52) Classification Coopérative des Brevets (CPC):
**G01R 31/1272; G01R 31/1209**

(54) **PROCÉDÉ DE CLASSIFICATION DE DÉCHARGE PARTIELLE DANS UN CONDUCTEUR ÉLECTRIQUE D'UN APPAREIL ÉLECTRIQUE DE MOYENNE TENSION**

VERFAHREN ZUR KLASSIFIZIERUNG VON TEILENTLADUNGEN IN EINEM ELEKTRISCHEN LEITER EINES ELEKTRISCHEN MITTELSPANNUNGSGERÄTS

METHOD FOR CLASSIFYING PARTIAL DISCHARGE IN AN ELECTRICAL CONDUCTOR OF A MEDIUM VOLTAGE ELECTRICAL DEVICE

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **25.10.2021 FR 2111326**

(43) Date de publication de la demande:
**26.04.2023 Bulletin 2023/17**

(73) Titulaire: **Schneider Electric Industries SAS 92500 Rueil-Malmaison (FR)**

(72) Inventeurs:
• **BOGUSLAWSKI, Bartosz 38100 Grenoble (FR)**
• **ALBERTO, Diego 38700 Corenc (FR)**

(74) Mandataire: **Schneider Electric Service Propriété Industrielle 35, rue Joseph Monier 92500 Rueil-Malmaison (FR)**

(56) Documents cités:
**WO-A1-2020/160590     US-A1- 2015 185 270**

## Description

### Domaine technique

La présente invention se rapporte au domaine des appareils électriques à moyenne tension ou à haute tension.

### Technique antérieure

Les appareils électriques opérant sous moyenne tension ou haute tension peuvent être sujet à des décharges partielles entre les conducteurs électriques et l'environnement avoisinant. On entend par décharge partielle une décharge électrique localisée dans une isolation électrique. La décharge est dite partielle car elle ne court-circuite pas l'ensemble de l'isolation. Ces décharges partielles peuvent se propager dans l'air, ou à l'intérieur même de la matière isolante. Ces décharges partielles n'affectent pas à court terme le fonctionnement de l'appareil électrique concerné, mais accélèrent le vieillissement des isolants. Lorsque les isolants sont trop endommagés, un arc électrique franc peut survenir, ce qui peut conduire à la destruction de l'appareil électrique et poser des risques majeurs pour les personnes travaillant à proximité. Ainsi, les décharges partielles doivent être détectées afin de permettre une intervention avant un endommagement permanent, une destruction de l'appareil électrique concerné ou un incident de personne.

Il est ainsi souhaitable de détecter l'apparition de décharges partielles. Pour cela, diverses méthodes de détection des décharges partielles sont connues. Généralement, lorsqu'une décharge partielle est détectée, ces méthodes de détection permettent une analyse statistique basée par exemple sur les valeurs telles que maximum, minimum, moyenne, médiane, mais ne permettent pas de déterminer la classe à laquelle appartient cette décharge partielle. On entend par là qu'il n'est pas possible de savoir l'origine de la ou des décharges partielles détectées. Ainsi, l'origine des décharges partielles détectées peut être difficile à identifier et par conséquent à corriger.

US 2015/185270 A1 divulgue une méthode de reconnaissance du schéma de décharge partielle d'un transformateur basée sur l'algorithme de décomposition en valeurs singulières.

Il existe un besoin de disposer d'une méthode permettant de déterminer, par famille de décharge partielle (dans le gaz ou l'air, dans les matériaux isolants ou à la surface de ces matériaux), l'origine de décharge partielle susceptible de se produire dans un appareil électrique de moyenne ou haute tension, autrement dit de réaliser une classification du type des décharges détectées.

### Résumé

A cette fin, l'invention selon la revendication 1 propose un procédé de classification de décharge partielle dans un isolant d'un conducteur électrique d'un appareil électrique de moyenne tension ou de haute tension, le procédé permettant de classer une décharge partielle parmi au moins une première classe et une deuxième classe distincte de la première classe,
le procédé comportant les étapes :

- obtenir un ensemble d'échantillons correspondant chacun à au moins une décharge partielle,
- déterminer un modèle de classification par apprentissage automatique à partir d'au moins une grandeur statistique des échantillons de l'ensemble,
- acquérir un nouvel échantillon correspondant à au moins une décharge partielle,
- déterminer la classe de la décharge partielle associée au nouvel échantillon acquis à partir du modèle de classification.

Le procédé de classification proposé est basé sur un apprentissage automatique pour déterminer la classe à laquelle appartient la décharge partielle détectée. Cet apprentissage automatique utilise au moins une grandeur statistique, ou paramètre statistique, déterminé à partir d'un ensemble d'échantillons dans lequel chaque échantillon correspond à au moins une décharge partielle. Grâce à ce principe, les décharges partielles survenant pendant le fonctionnement de l'appareil électrique peuvent être plus finement caractérisées qu'avec les méthodes selon l'art antérieur. Grâce au procédé de classification des décharges partielles, des actions correctives plus efficaces peuvent être mises en œuvre.

Les caractéristiques listées dans les paragraphes suivant peuvent être mises en œuvre indépendamment les unes des autres ou selon toutes les combinaisons techniquement possibles :
Chaque échantillon de l'ensemble d'échantillons correspondant chacun à au moins une décharge partielle est mesuré avec au moins un capteur. Le capteur est configuré pour fournir un signal vibratoire associé à l'isolant du conducteur électrique.

Selon un mode de réalisation, l'ensemble d'échantillons à classifier comprend par exemple deux classes.

Une première classe de décharge partielle est par exemple une décharge partielle se produisant dans un connecteur relié au conducteur électrique de l'appareil électrique.

Une deuxième classe de décharge partielle est par exemple une décharge partielle se produisant du fait d'une déconnexion d'un panier de terre de l'appareil électrique.

Selon un autre mode de réalisation, l'ensemble d'échantillons à classifier comprend par exemple trois classes distinctes.

L'ensemble d'échantillons à classifier peut comprendre plus de trois classes distinctes.

Chaque échantillon acquis est un échantillon d'un signal vibratoire associé au conducteur électrique.

Selon un mode de réalisation, le signal vibratoire est un signal représentatif d'une vibration de l'isolant du conducteur électrique.

Le procédé de classification des décharges partielles comprend également des étapes préalables permettant tout d'abord de détecter les décharges partielles. Afin de détecter la présence d'une décharge partielle, le procédé comporte les sous-étapes :

> i) acquérir un ensemble d'échantillons successifs d'un signal vibratoire associé au conducteur électrique,
> ii) déterminer une valeur modélisée d'un échantillon suivant à partir de l'ensemble d'échantillons acquis et d'un modèle de prédiction,
> le modèle de prédiction étant obtenu par apprentissage automatique du signal vibratoire,
> iii) acquérir l'échantillon suivant du signal vibratoire,
> iv) calculer une différence entre la valeur de l'échantillon acquis et la valeur modélisée,
> v) Si la différence calculée est supérieure à un seuil prédéterminé, détecter une décharge partielle dans le conducteur électrique,

et l'apprentissage automatique est réalisé à partir d'un ensemble d'échantillons acquis dans des conditions de référence dans lesquelles le conducteur électrique est exempt de décharge partielle.

Selon un exemple de mise en œuvre du procédé, la tension dans le conducteur électrique est périodique de période, le nouvel échantillon acquis est obtenu par intégration d'un signal vibratoire pendant une fenêtre temporelle d'acquisition, et une durée de la fenêtre temporelle d'acquisition est égale à un multiple de la période de la tension.

De préférence, le multiple de la période de la tension est une valeur entière comprise par exemple entre 1 et 10.

La durée de la fenêtre temporelle d'acquisition est par exemple égale à la période de la tension, préférablement égale à trois fois la période de la tension, plus préférablement égale à cinq fois la période de la tension.

En variante, une durée entre deux échantillons successifs du signal du capteur est inférieure à un dixième de la période de la tension, de préférence inférieure à la période divisée par 20.

Selon l'invention, le procédé comporte l'étape :

- déterminer une durée séparant deux échantillons consécutifs de l'ensemble d'échantillons correspondant chacun à au moins une décharge partielle, et dans lequel la grandeur statistique de l'ensemble d'échantillons à classifier comprend la durée séparant deux échantillons consécutifs de l'ensemble d'échantillons à classifier.

Selon un mode de réalisation, le procédé comporte l'étape :

- calculer une fonction de distribution des valeurs de chaque échantillon de l'ensemble d'échantillons à classifier.

Selon un exemple de mise en œuvre du procédé, la grandeur statistique comprend le coefficient d'asymétrie de la fonction de distribution obtenue.

En variante ou de manière complémentaire, la grandeur statistique comprend le coefficient d'aplatissement de la fonction de distribution obtenue.

Selon un mode de réalisation, la grandeur statistique comprend le coefficient d'asymétrie et le coefficient d'aplatissement de la fonction de distribution obtenue.

Selon un mode de réalisation, le procédé comporte l'étape :

- déterminer parmi l'ensemble d'échantillons correspondant chacun à au moins une décharge partielle une fraction d'échantillons ayant une valeur positive, et la grandeur statistique comprend la fraction d'échantillons ayant une valeur positive.

En variante ou de manière complémentaire, le procédé comporte l'étape :

- déterminer parmi l'ensemble d'échantillons correspondant chacun à au moins une décharge partielle une fraction d'échantillons ayant une valeur négative, et la grandeur statistique comprend la fraction d'échantillons ayant une valeur négative.

Selon un mode de réalisation, la tension présente des variations périodiques, et la grandeur statistique comprend un phasage du nouvel échantillon acquis par rapport aux variations périodiques de la tension.

Selon un mode de réalisation, le procédé comporte successivement les étapes :

- acquérir un ensemble d'échantillons de référence comportant un premier sous-ensemble correspondant à la première classe et un deuxième sous-ensemble correspondant à la deuxième classe,
- entrainer le modèle de classification avec au moins une partie de l'ensemble d'échantillons de référence.

De préférence, l'ensemble d'échantillons de référence est obtenu dans des conditions de référence dans lesquelles des décharges partielles se produisent dans le conducteur électrique.

L'ensemble d'échantillons de référence comprend par exemple entre 100 et 500 échantillons.

Selon un exemple d'utilisation du procédé, le modèle de classification est entrainé en utilisant par exemple 70% des échantillons de l'ensemble d'échantillons de référence.

Selon cet exemple d'utilisation du procédé, le modèle de classification est testé en utilisant par exemple 30% des échantillons de l'ensemble d'échantillons de référence.

Selon un mode de mise en œuvre du procédé, celui-ci comporte successivement les étapes :

- acquérir un ensemble d'échantillons de référence comportant un premier sous-ensemble correspondant à la première classe et un deuxième sous-ensemble correspondant à la deuxième classe,
- déterminer une moyenne (Moy) et un écart type (S) des échantillons de l'ensemble d'échantillons de référence,
- normaliser les valeurs de l'ensemble d'échantillons de référence de façon à obtenir un ensemble d'échantillons de référence normalisés, la valeur normalisée ($Eref\_N_k$) d'un échantillon ($Eref_k$) étant égale à :

$$ERef\_N_k = \left( \frac{ERef_k - Moy}{S} \right)$$

- entrainer le modèle de classification avec au moins une partie des valeurs de l'ensemble de valeurs normalisées.

Par exemple, l'étape de normalisation des valeurs de l'ensemble d'échantillons à classifier comporte les étapes :

- déterminer la moyenne et l'écart type des échantillons de l'ensemble d'échantillons de référence,
- pour chaque échantillon du premier sous-ensemble, calculer une valeur corrigée, la valeur corrigée étant obtenue en soustrayant à la valeur de échantillon la valeur de la moyenne déterminée, puis en divisant le résultat de la soustraction par l'écart type déterminé,
- pour chaque échantillon du deuxième sous-ensemble, calculer une valeur corrigée, la valeur corrigée étant obtenue en soustrayant à la valeur de échantillon la valeur de la moyenne déterminée, puis en divisant le résultat de la soustraction par l'écart type déterminé.

L'invention se rapporte également à un appareil électrique de moyenne tension ou de haute tension, l'appareil électrique comportant :

- un conducteur électrique,
- un capteur configuré pour fournir un signal vibratoire associé à un isolant du conducteur électrique,

- une unité électronique de contrôle configurée pour mettre en œuvre le procédé de classification de décharge partielle selon la revendication 1.

Selon un mode de réalisation, le capteur est configuré pour fournir un signal représentatif d'une vibration de l'isolant du conducteur électrique.

Le capteur est un capteur de vibration.

Le capteur est configuré pour fournir un signal représentatif d'une accélération de l'isolant du conducteur électrique.

Le capteur de vibration est fixé à une surface extérieure du conducteur électrique. Plus précisément, le conducteur électrique est entouré d'un isolant formant gaine, et le capteur de vibration est fixé sur la surface extérieure de l'isolant.

Le capteur de vibration est un capteur de type piézo-électrique.

Selon un mode de réalisation, la bande passante du capteur de vibration est comprise entre 1 kHz et 300 kHz.

Selon un exemple de mise en œuvre du procédé, le capteur de vibration délivre un signal analogique.

En variante, le capteur de vibration délivre un signal numérique.

## Brève description des dessins

D'autres caractéristiques, détails et avantages apparaîtront à la lecture de la description détaillée ci-après, et à l'analyse des dessins annexés, sur lesquels :

[Fig. 1] est une représentation schématique d'un appareil électrique sur lequel le procédé selon l'invention est mis en œuvre,

[Fig. 2] est une représentation schématique de détail de l'appareil électrique de la figure 1,

[Fig. 3] est une représentation schématique de l'évolution temporelle de paramètres d'un mode de réalisation du procédé selon l'invention.

[Fig. 4] est une autre représentation de l'évolution temporelle de paramètres d'un mode de réalisation du procédé selon l'invention,

[Fig. 5] est une représentation schématique de paramètres statistiques du procédé,

[Fig. 6] est une représentation schématique d'autres paramètres statistiques du procédé,

[Fig. 7] est un schéma-bloc illustrant différentes étapes du procédé selon l'invention.

## Description des modes de réalisation

Afin de faciliter la lecture des figures, les différents éléments ne sont pas nécessairement représentés à l'échelle. Sur ces figures, les éléments identiques portent les mêmes références. Certains éléments ou paramètres peuvent être indexés, c'est-à-dire désignés par exemple par premier élément ou deuxième élément, ou encore premier paramètre et second paramètre, etc. Cette indexation a pour but de différencier des éléments ou paramètres similaires, mais non identiques. Cette indexation n'implique pas une priorité d'un élément, ou paramètre par rapport à un autre et on peut interchanger les dénominations. Quand il est précisé qu'un dispositif comporte un élément donné, cela n'exclut pas la présence d'autres éléments dans ce dispositif.

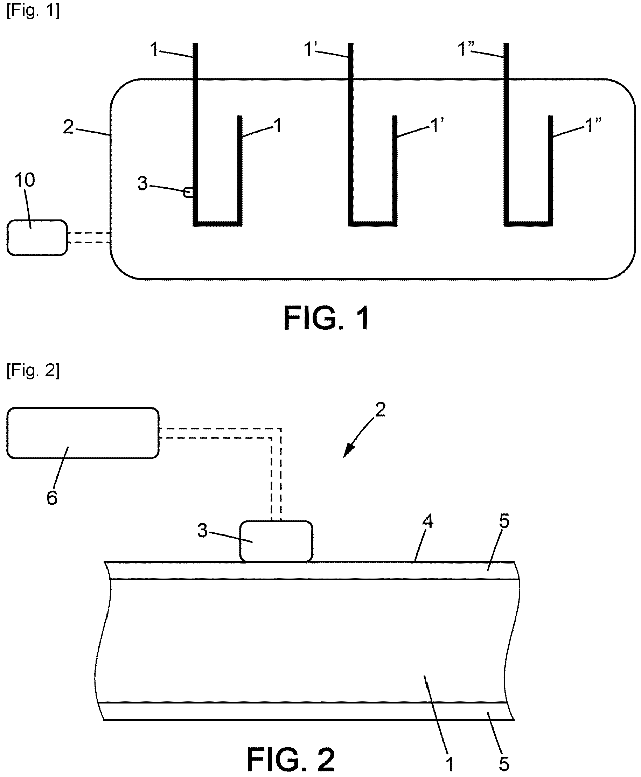

On a représenté sur la figure 1 un appareil électrique 2 de moyenne tension ou de haute tension, l'appareil électrique 2 comportant :

- un conducteur électrique 1,
- un capteur 3 configuré pour fournir un signal vibratoire V associé à un isolant 5 du conducteur électrique 1,
- une unité électronique de contrôle 10 configurée pour mettre en œuvre le procédé de classification de décharge partielle selon l'invention.

L'appareil électrique 2 comporte plusieurs conducteurs électriques. Par exemple, l'appareil électrique 2 comporte trois conducteurs électriques 1, 1', 1" correspondant aux trois phases d'un réseau électrique triphasé. Le procédé selon l'invention est être appliqué à chacun des conducteurs électriques 1, 1', 1".

L'appareil électrique 2 est un équipement à moyenne tension, c'est-à-dire une tension comprise entre 1 kV et 52 kV. L'appareil électrique 2 peut aussi être un équipement à haute tension. L'appareil électrique 2 peut être par exemple un disjoncteur, un sectionneur ou un interrupteur. En outre, l'invention peut s'appliquer aussi bien au courant alternatif qu'au courant continu, notamment lorsqu'il n'est pas fait mention d'une périodicité du courant électrique.

Le procédé selon l'invention est un procédé de classification de décharge partielle dans un isolant 5 d'un conducteur électrique 1 d'un appareil électrique 2 de moyenne tension ou de haute tension, le procédé permettant de classer une décharge partielle parmi au moins une première classe C1 et une deuxième classe C2 distincte de la première classe C1, le procédé comportant les étapes :

- obtenir un ensemble P d'échantillons $E_1...$, $E_n$ correspondant chacun à au moins une décharge partielle, (étape 51)
- déterminer un modèle de classification M2 par apprentissage automatique à partir d'au moins une grandeur statistique G des échantillons de l'ensemble P, (étape 52)
- acquérir un nouvel échantillon $E_{n+1}$ correspondant à au moins une décharge partielle, (étape 53)
- déterminer la classe C1, C2 de la décharge partielle associée au nouvel échantillon acquis $E_{n+1}$ à partir du modèle de classification M2. (étape 54)

Le procédé de classification proposé est basé sur un apprentissage automatique pour déterminer la classe à laquelle appartient la décharge partielle détectée. Cet apprentissage automatique utilise au moins une grandeur statistique, ou paramètre statistique, déterminé à partir d'un ensemble d'échantillons dans lequel chaque échantillon correspond à au moins une décharge partielle. Grâce à ce principe, les décharges partielles survenant pendant le fonctionnement de l'appareil électrique peuvent être plus finement caractérisées qu'avec les méthodes selon l'art antérieur. Grâce au procédé de classification des décharges partielles, l'origine et la localisation des décharges partielles peuvent être déterminées plus précisément, ce qui permet de mettre en œuvre des actions correctives plus efficaces.

Chaque échantillon de l'ensemble P correspond à au moins une décharge partielle, c'est-à-dire que l'occurrence d'au moins une décharge partielle est associée à cet échantillon. Il est possible que plusieurs décharges partielles se produisent dans l'intervalle de temps séparant deux échantillons successifs. Dans ce cas, plusieurs occurrences de décharges partielles sont associées à un même échantillon.

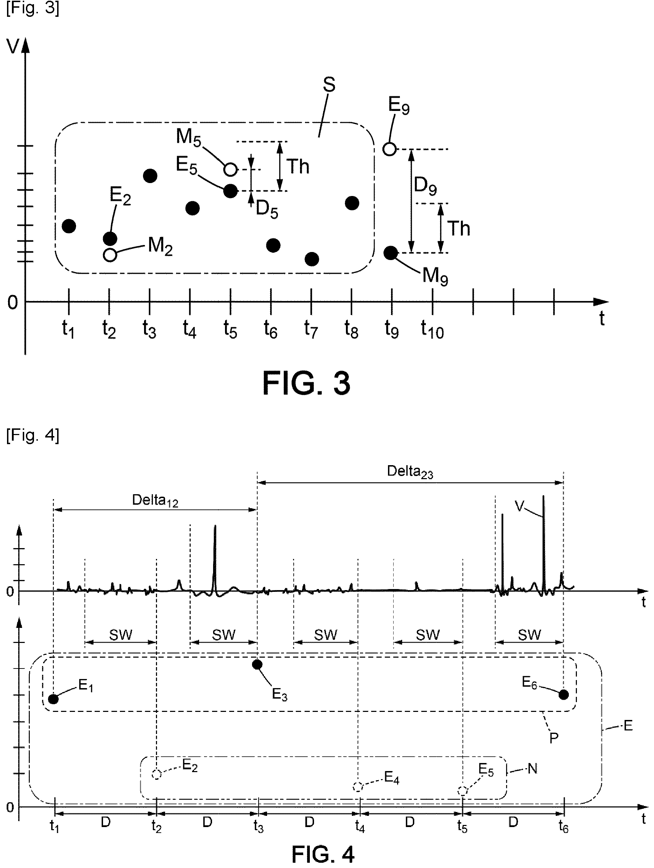

L'ensemble P d'échantillons correspondant chacun à au moins une décharge partielle est un sous-ensemble de l'ensemble E des échantillons acquis. L'ensemble E des échantillons acquis comprend aussi des échantillons pour lesquels aucune décharge partielle ne s'est produite. En d'autres termes, l'ensemble E des échantillons acquis comprend le sous-ensemble P des échantillons correspondant à au moins une décharge partielle et le sous-ensemble N des échantillons correspondants chacun à une absence de décharge partielle. Une détermination de la classe de la décharge partielle, c'est-à-dire du type de décharge partielle, est réalisée pour l'ensemble P des échantillons correspondant à au moins une décharge partielle. Aucune classification n'est à faire pour le sous-ensemble N des échantillons correspondants chacun à une absence de décharge partielle. La figure 4 illustre schématiquement l'ensemble E de tous les échantillons acquis au cours du temps, le sous-ensemble P des échantillons associés à une décharge partielle, et le sous-ensemble N des échantillons pour lesquels aucune décharge partielle ne s'est produite. Pour des raisons de clarté, seuls quelques échantillons ont été représentés. Les échantillons $E_1$, $E_3$ et $E_6$ sont associés à l'occurrence d'une décharge partielle. Les échantillons $E_2$, $E_4$, $E_5$ sont associés à une absence de décharge partielle.

Chaque échantillon $E_1...$, $E_n$ de l'ensemble P d'échantillons correspondant chacun à au moins une décharge partielle est mesuré avec au moins un capteur 3. Le capteur 3 est configuré pour fournir un signal vibratoire associé à l'isolant 5 du conducteur électrique 1. En d'autres termes, le capteur 3 est configuré pour fournir un signal représentatif d'une vibration de l'isolant 5 du conducteur électrique 1. L'isolant 5 entoure le conducteur électrique 1 et forme une gaine isolante autour de celui-ci.

Le capteur 3 est un capteur de vibration. Comme schématisé sur la figure 2, le capteur de vibration 3 est fixé à une surface extérieure 4 du conducteur électrique 1. Plus précisément, le conducteur électrique 1 est entouré d'un isolant 5 formant gaine. Le capteur de vibration 3 est fixé sur la surface extérieure de l'isolant 5. Le capteur de vibration 3 est rigidement lié à la surface extérieure 4 du conducteur électrique 1. Le capteur de vibration 3 mesure ainsi les vibrations se propageant à la surface du conducteur électrique au voisinage du capteur 3.

Le capteur 3 de vibration est par exemple un capteur de type piézo-électrique. Autrement dit, le capteur 3 comprend un élément piézo-électrique et les vibrations mécaniques du conducteur électrique 1 modifient la pression exercée sur l'élément piézo-électrique. Une tension électrique apparait ainsi aux bornes de l'élément piézo-électrique. Cette tension électrique aux bornes de l'élément piézo-électrique est amplifiée de façon à fournir un signal de sortie exploitable. Un module électronique de traitement 6 permet de traiter le signal du capteur 3. Ce module 6 de traitement du signal peut être distinct de l'unité électronique de contrôle 10. Selon un autre exemple de mise en œuvre, le module 6 de traitement du signal peut faire partie de l'unité électronique de contrôle 10.

Selon un mode de réalisation, la bande passante du capteur 3 de vibration est comprise entre 1 kHz et 300 kHz.

Selon le mode de réalisation illustré, le capteur 3 est configuré pour fournir un signal V représentatif d'une accélération de l'isolant 5 du conducteur électrique 1. Autrement dit, le capteur 3 est un capteur d'accélération.

Selon un exemple de mise en œuvre du procédé, le capteur 3 de vibration délivre un signal analogique. En variante, le capteur 3 de vibration délivre un signal numérique.

Les échantillons successifs $E_1$, ..., $E_n$ du signal du capteur 3 correspondent respectivement à des instants successifs de mesure $t_1$, ..., $t_n$. Lorsqu'un ensemble S d'échantillons successifs $E_1$, ..., $E_n$ a été acquis et que l'échantillon $E_n$ est l'échantillon le plus récent, l'échantillon suivant $E_{n+1}$ correspond à la valeur fournie par le capteur à l'instant $t_{n+1}$.

Lorsqu'une décharge partielle est déterminée, la décharge partielle déterminée a eu lieu entre l'instant $t_n$ et l'instant $t_{n+1}$.

Un échantillon de mesure $E_n$ du signal du capteur 3 peut correspondre par exemple à une valeur échantillonnée à un instant donné $t_n$ du signal instantané du capteur 3.

L'acquisition des échantillons successifs $E_1$, ..., $E_n$ du signal du capteur 3 peut être réalisée avec une fréquence d'échantillonnage fixe. En variante, l'acquisition des échantillons successifs $E_1$, ..., $E_n$ du signal du capteur 3 peut être réalisée avec une fréquence d'échantillonnage variable.

La fréquence échantillonnage est comprise entre 1 kHz et 1000 kHz.

Selon un mode de réalisation, l'ensemble P d'échantillons à classifier comprend par exemple deux classes C1, C2.

Une classe correspond à l'origine de la décharge partielle, c'est-à-dire à la famille de la décharge partielle qui s'est produite. En d'autres termes, une classe correspond à un type de décharge partielle.

Une première classe C1 de décharge partielle est par exemple une décharge partielle se produisant dans un connecteur relié au conducteur électrique 1 de l'appareil électrique 2.

Une deuxième classe C2 de décharge partielle est par exemple une décharge partielle se produisant du fait d'une déconnexion d'un panier de terre de l'appareil électrique 2.

Les appellations première classe C1 et deuxième classe C2 n'impliquent pas une importance particulière d'une classe par rapport à l'autre classe.

Selon un autre mode de réalisation, l'ensemble P d'échantillons à classifier comprend par exemple trois classes distinctes C1, C2, C3. L'ensemble P d'échantillons à classifier peut aussi comprendre plus de trois classes distinctes.

Chaque échantillon acquis est un échantillon d'un signal vibratoire V associé au conducteur électrique 1. Le signal vibratoire V est un signal représentatif d'une vibration de l'isolant 5 du conducteur électrique 1. Sur les figures illustratives, une valeur élevée du signal vibratoire V traduit des valeurs de vibration élevées. A l'inverse, un signal proche de zéro traduit des faibles valeurs de vibration.

Le procédé de classification des décharges partielles comprend également des étapes préalables permettant tout d'abord de détecter les décharges partielles. Afin de détecter la présence d'une décharge partielle, le procédé comporte les sous-étapes :

i) acquérir un ensemble $S_n$ d'échantillons successifs $E_1$, ..., $E_n$ d'un signal vibratoire V associé au conducteur électrique 1,
ii) déterminer une valeur modélisée $M_{n+1}$ d'un échantillon suivant $E_{n+1}$ à partir de l'ensemble $S_n$ d'échantillons acquis et d'un modèle de prédiction M1,
le modèle de prédiction M1 étant obtenu par apprentissage automatique du signal vibratoire V à partir d'un ensemble $V_p$ d'échantillons acquis dans des conditions de référence CRef dans lesquelles le conducteur électrique 1 est exempt de décharge partielle,
iii) acquérir l'échantillon suivant $E_{n+1}$ du signal vibratoire V,
iv) calculer une différence $D_{n+1}$ entre la valeur de l'échantillon acquis $E_{n+1}$ et la valeur modélisée $M_{n+1}$,
v) Si la différence calculée $D_{n+1}$ est supérieure à un seuil prédéterminé Th, détecter une décharge partielle dans le conducteur électrique 1.

Les sous-étapes permettant une détection des décharges partielles dans le conducteur électrique 1 reposent à la fois sur une mesure réellement mesurée d'un signal vibratoire V associé au conducteur électrique 1, et sur un modèle de prédiction M1 calculant l'évolution attendue de ce signal vibratoire V. Un écart trop grand entre le signal modélisé et le signal réellement mesuré indique qu'une décharge partielle a eu lieu. Le modèle de prédiction M1 étant obtenu par apprentissage automatique, celui-ci peut ainsi être automatiquement adapté aux caractéristiques réelles de chaque appareil électrique 2 pour lequel le procédé est mis en œuvre. Les dispersions des caractéristiques entre appareils électriques sont ainsi prises en compte automatiquement, ce qui facilite la mise au point du procédé ainsi que son efficacité.

La figure 3 illustre de manière schématique les sous-étapes de détection d'une décharge partielle.

Le point $E_2$ représente la valeur du signal V mesurée à l'instant $t_2$. Le point $E_5$ représente la valeur du signal V mesurée à l'instant ts, et le point $E_9$ représente la valeur du signal V mesurée à l'instant $t_9$. Le point $M_5$ représente la valeur modélisée par le modèle de prédiction M1 de l'échantillon $E_5$, et de même le point $M_9$ représente la valeur modélisée de l'échantillon $E_9$. Afin de simplifier la figure, les points $M_1$, $M_3$ ainsi que $M_6$ à $M_8$ n'ont pas été représentés. La différence $D_9$ entre l'échantillon acquis $E_9$ et la valeur modélisée $M_9$ est supérieure au seuil Th. Cela indique donc qu'un évènement anormal s'est produit entre l'instant $t_8$ et l'instant $t_9$. La différence $D_5$ entre l'échantillon acquis $E_5$ et la valeur modélisée $M_5$ est inférieure au seuil Th. Cela indique qu'aucun évènement anormal ne s'est produit entre l'instant $t_4$ et l'instant $t_5$. Sur la figure 3, pour simplifier seules des valeurs positives du signal V ont été représentées, mais le signal peut également prendre des valeurs négatives.

L'ensemble S d'échantillons successifs $E_1$, ..., $E_n$ du signal du capteur 3 pris en compte pour déterminer une valeur modélisée $M_{n+1}$ de l'échantillon suivant $E_{n+1}$ comprend un nombre fixe d'échantillons, le nombre fixe d'échantillons étant compris par exemple entre 10 et 20. Par exemple, la valeur modélisée de l'échantillon suivant est obtenue à partir des 15 échantillons préalablement acquis. Plus généralement, l'ensemble S d'échantillons successifs $E_1$, ..., $E_n$ du signal du capteur 3 pris en compte pour déterminer une valeur modélisée $M_{n+1}$ de l'échantillon suivant $E_{n+1}$ peut comprendre un nombre d'échantillons compris par exemple entre 4 et 20.

Dans le cas où la valeur mesurée $E_{n+1}$ est éloignée de la valeur prédite $M_{n+1}$, le point de mesure correspond à une décharge partielle. La décharge partielle détectée est ensuite classifiée par le procédé selon l'invention, c'est-à-dire que le type de la décharge partielle est déterminé. Lorsque la valeur mesurée $E_{n+1}$ est proche de la valeur prédite $M_{n+1}$, l'échantillon de mesure $E_{n+1}$ correspond à un fonctionnement sans décharge partielle. L'échantillon de mesure $E_{n+1}$ n'est donc pas intégré à l'ensemble P des points pour lesquels une classification des décharges partielles est effectuée.

L'apprentissage automatique du modèle de prédiction M1 est réalisé à partir d'un ensemble $V_p$ d'échantillons acquis dans des conditions de référence CRef dans lesquelles l'isolant 5 du conducteur électrique 1 est exempt de décharge partielle. L'apprentissage automatique est ainsi réalisé à partir d'un ensemble $V_p$ d'échantillons dans lequel les décharges partielles à détecter sont absentes. L'ensemble des valeurs possibles du signal vibratoire en absence de décharge partielle peut ainsi être caractérisé, et correspond au bruit nominal du signal vibratoire en absence de décharge partielle. L'apprentissage automatique du bruit nominal du signal vibratoire permet d'améliorer la performance des étapes de détection de décharge partielle, aussi bien pour le taux de non-détection que pour le taux de fausse détection. Ces conditions d'apprentissage du modèle de prédiction M1 sont une période de fonctionnement débutant à la première mise en service de l'appareil électrique 2 et de durée égale à une première durée d'utilisation prédéterminée D1 de l'appareil électrique 2. Autrement dit, la première durée d'utilisation prédéterminée D1 pendant laquelle l'apprentissage automatique du modèle de prédiction M1 peut être réalisé correspond au fonctionnement à l'état neuf de l'appareil électrique 2. Pendant cette période, le fonctionnement de l'appareil électrique 2 est exempt de décharge partielle. Autrement dit, pendant cette période aucun évènement anormal indésirable ne se produit, et le signal délivré par le capteur 3 correspond au bruit résiduel de mesure. La dégradation des propriétés diélectriques de l'appareil électrique 2 étant un phénomène lent, l'état neuf de l'appareil électrique peut durer en réalité pendant plusieurs dizaines d'heures.

Selon un exemple de mise en œuvre du procédé, la tension dans le conducteur électrique 1 est périodique de période T, le nouvel échantillon acquis $E_{n+1}$ est obtenu par intégration d'un signal vibratoire V pendant une fenêtre temporelle SW d'acquisition, et une durée D de la fenêtre temporelle SW d'acquisition est égale à un multiple k de la période T de la tension.

La tension d'alimentation de l'appareil électrique 2 est périodique de période T. La durée écoulée entre deux échantillons successifs peut être supérieure à la durée de la fenêtre temporelle SW.

De préférence, le multiple k de la période T de la tension est une valeur entière comprise par exemple entre 1 et 10. Le multiple k peut prendre toutes les valeurs entières entre 1, valeur incluse, et 10, valeur également incluse.

La durée D de la fenêtre temporelle SW d'acquisition est par exemple égale à la période T de la tension, préférablement égale à trois fois la période T de la tension, plus préférablement égale à cinq fois la période T de la tension. Dans l'analyse, on ne considère évidemment que les fenêtres temporelles dans lesquelles au moins une décharge partielle est identifiée.

En augmentant la durée d'acquisition pendant laquelle le signal vibratoire est analysé, la précision de la classification peut être améliorée. Autrement dit, le taux d'identification correcte de la classe de la décharge partielle est augmenté. Celui-ci peut passer par exemple d'une valeur de 85% lorsque chaque échantillon correspond à une durée égale à une période de la tension à une valeur de 97% lorsque chaque échantillon correspond à une durée égale à cinq fois la période de la tension.

En variante, une durée D entre deux échantillons successifs $E_1$, ..., $E_n$ du signal du capteur 3 est inférieure à un dixième de la période T de la tension, de préférence inférieure à la période T divisée par 20. Une faible durée entre deux échantillons successifs permet de déterminer un phasage des décharges partielles détectées par rapport aux variations de la tension de l'appareil électrique 2.

Selon l'invention, le procédé comporte l'étape :

- déterminer une durée Delta séparant deux échantillons consécutifs de l'ensemble P d'échantillons correspondant chacun à au moins une décharge partielle, et dans lequel la grandeur statistique G de l'ensemble P d'échantillons à classifier comprend la durée Delta séparant deux échantillons consécutifs de l'ensemble P d'échantillons à classifier.

Sur l'exemple de la figure 4, la durée $Delta_{12}$ correspond à la durée s'étant écoulée entre l'échantillon $E_1$, correspondant à la première d'occurrence d'une décharge partielle, et l'échantillon $E_3$ qui correspond lui à la deuxième occurrence d'une décharge partielle. La durée $Delta_{23}$ correspond à la durée entre l'échantillon $E_3$ et l'échantillon $E_6$, l'échantillon $E_6$ qui correspond à la troisième occurrence d'une décharge partielle. En effet, les échantillons $E_2$, $E_3$ et $E_4$ sont représentatifs d'une absence de décharge partielle.

La durée Delta séparant deux échantillons consécutifs de l'ensemble P peut être exprimée en temps absolu. On entend par là que la durée Delta est égale à la différence de la valeur de l'instant d'acquisition d'un échantillon appartenant à l'ensemble P et de la valeur de l'instant d'acquisition de l'échantillon précédent appartenant à l'ensemble P.

Alternativement, la durée Delta séparant deux échantillons consécutifs de l'ensemble P peut être exprimée en temps relatif. On entend par là que la durée Delta est égale au nombre de fenêtres temporelles d'acquisition séparant deux échantillons successifs appartenant à l'ensemble P. La durée Delta est alors égale au rapport de la différence de la valeur de l'instant d'acquisition d'un échantillon appartenant à l'ensemble P et de la valeur de l'instant d'acquisition de l'échantillon précédent appartenant à l'ensemble P, et de la durée SW de la fenêtre temporelle d'acquisition.

Selon un mode de réalisation, le procédé comporte l'étape :

- calculer une fonction de distribution D des valeurs de chaque échantillon de l'ensemble P d'échantillons à classifier.

Le procédé comprend ainsi une étape dans laquelle une distribution de la valeur des échantillons est établie. Plus précisément, l'ensemble des valeurs des échantillons de l'ensemble P est découpé en un ensemble d'intervalles contigus, et la probabilité qu'un échantillon appartiennent à un intervalle donné est déterminée. Pour cela, le nombre d'échantillons appartenant à chaque intervalle est déterminé, et divisé par le nombre total d'échantillons. De préférence, les intervalles ont la même largeur. L'ensemble des valeurs des échantillons acquis peut par exemple être découpé en 10 intervalles.

Selon un exemple de mise en œuvre du procédé, la grandeur statistique G comprend le coefficient d'asymétrie de la fonction de distribution D obtenue. On entend par coefficient d'asymétrie d'une variable aléatoire X de moyenne M et d'écart type S l'espérance mathématique de la quantité :

$$\left[ \left( \frac{X-M}{S} \right)^3 \right]$$

Autrement dit, le degré de symétrie de la distribution D obtenue est pris en compte pour réaliser la classification des décharges partielles.

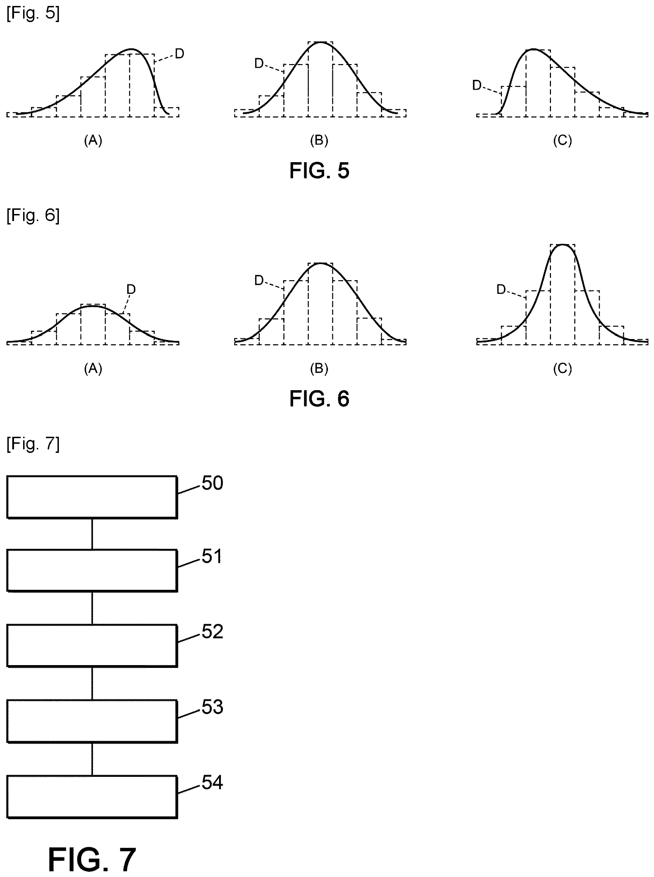

La figure 5 illustre différents coefficients d'asymétrie. La partie A de la figure 5 illustre un coefficient d'asymétrie négatif, c'est-à-dire que la distribution est décalée à droite de la médiane. La partie B correspond à un coefficient d'asymétrie nul, pour lequel la distribution est symétrique. La partie C illustre un coefficient d'asymétrie positif, c'est-à-dire que la distribution est décalée à gauche de la médiane.

En variante ou de manière complémentaire, la grandeur statistique G comprend le coefficient d'aplatissement de la fonction de distribution D obtenue. On entend par coefficient d'aplatissement d'une variable aléatoire X de moyenne M et d'écart type S l'espérance mathématique de la quantité :

$$\left[ \left( \frac{X-M}{S} \right)^4 \right]$$

Autrement dit, le degré d'aplatissement de la distribution D obtenue est pris en compte pour réaliser la classification des décharges partielles.

La figure 6 illustre différents coefficients d'aplatissement. La partie A de la figure montre un coefficient d'aplatissement négatif de la distribution D, pour lequel la distribution est davantage aplatie que la distribution normale. La partie B montre montre un coefficient d'aplatissement nul, correspond à la distribution normale. La partie C montre un coefficient d'aplatissement positif, pour lequel la distribution D est plus pointue que la distribution normale.

Selon un mode de réalisation, la grandeur statistique G comprend le coefficient d'asymétrie et le coefficient d'aplatissement de la fonction de distribution D obtenue. Le coefficient d'asymétrie et le coefficient d'aplatissement sont ainsi utilisés conjointement afin de réaliser la classification de l'ensemble des décharges partielles. L'utilisation conjointe de ces deux paramètres statistiques permet d'améliorer la précision de la classification par rapport à l'utilisation d'un seul paramètre.

Selon un mode de réalisation, le procédé comporte l'étape :

- déterminer parmi l'ensemble P d'échantillons $E_1$..., $E_n$ correspondant chacun à au moins une décharge partielle une fraction d'échantillons ayant une valeur positive, et la grandeur statistique G comprend la fraction d'échantillons ayant une valeur positive.

En variante ou de manière complémentaire, le procédé comporte l'étape :

- déterminer parmi l'ensemble P d'échantillons $E_1$..., $E_n$ correspondant chacun à au moins une décharge partielle une fraction d'échantillons ayant une valeur négative, et la grandeur statistique G comprend la fraction d'échantillons ayant une valeur négative.

La fraction d'échantillons ayant une valeur négative est la valeur complémentaire, par rapport à 100%, de la fraction d'échantillons ayant une valeur positive. Par exemple, l'ensemble P des échantillons correspondant à au moins une décharge partielle peut comporter 80% de valeurs positives et 20% de valeurs négatives. La répartition entre les valeurs positives et les valeurs négatives est une autre grandeur permettant de réaliser la classification des décharges partielles.

Selon un mode de réalisation, la tension présente des variations périodiques, et la grandeur statistique G comprend un phasage du nouvel échantillon acquis $E_{n+1}$ par rapport aux variations périodiques de la tension.

Autrement dit, la position relative de l'échantillon suivant acquis $E_{n+1}$ correspondant à une décharge partielle, par rapport au cycle des variations périodiques de la tension, est un critère permettant de définir la classe de la décharge partielle. Par exemple, l'échantillon correspondant à la décharge partielle peut être proche d'une valeur maximum, ou d'une valeur minimum de la tension. L'échantillon peut aussi être voisin du zéro de la tension. Ceci indique quel type de décharge partielle s'est produit.

Selon un mode de réalisation, le procédé comporte successivement les étapes :

- acquérir un ensemble PRef d'échantillons de référence comportant un premier sous-ensemble PREf_1 correspondant à la première classe C1 et un deuxième sous-ensemble PRef_2 correspondant à la deuxième classe C2,
- entrainer le modèle de classification M2 avec au moins une partie de l'ensemble PRef d'échantillons de référence.

L'apprentissage automatique du modèle de classification M2 est réalisé à partir d'un ensemble PRef d'échantillons de référence comportant un premier sous-ensemble PREf_1 correspondant à la première classe C1 et un deuxième sous-ensemble PRef_2 correspondant à la deuxième classe C2.

De préférence, l'ensemble PRef d'échantillons de référence est obtenu dans des conditions de référence CRef dans lesquelles des décharges partielles se produisent dans le conducteur électrique 1.

Les échantillons de référence utilisés pour réaliser l'apprentissage automatique du modèle de classification M2 peuvent par exemple être obtenus avec un équipement électrique vieilli, dans lequel des décharges partielles se produisent régulièrement.

L'ensemble PRef d'échantillons de référence comprend par exemple entre 100 et 500 échantillons.

Lorsque le procédé de classification comprend plus de deux classes, l'ensemble PRef d'échantillons de référence comprend autant de sous-ensembles que de classes à identifier. L'apprentissage automatique du modèle de classification M2 est réalisé de façon à identifier chacune des classes de décharge partielle.

L'apprentissage automatique du modèle de classification M2 est un apprentissage supervisé.

Selon un exemple d'utilisation du procédé, le modèle de classification M2 est entrainé en utilisant par exemple 70% des échantillons de l'ensemble PRef d'échantillons de référence. Les échantillons pris en compte pour entrainer le modèle de classification M2 sont sélectionnés aléatoirement parmi l'ensemble PRef d'échantillons de référence.

Selon cet exemple d'utilisation du procédé, le modèle de classification M2 est testé en utilisant par exemple 30% des échantillons de l'ensemble PRef d'échantillons de référence.

La validation du modèle de classification M2 préalablement défini est ainsi effectuée en utilisant 30% des données de l'ensemble PRef d'échantillons de référence. Les échantillons pris en compte pour valider le modèle de classification M2 sont les échantillons restant une fois que les 70% d'échantillons utilisés pour l'apprentissage ont été sélectionnés.

Les paramètres du modèle de classification M2 sont mémorisés dans une unité électronique de contrôle. De même, les paramètres du modèle de prédiction M1 sont mémorisés dans une unité électronique de contrôle.

Selon un mode de mise en œuvre du procédé, celui-ci comporte successivement les étapes :

- acquérir un ensemble PRef d'échantillons de référence ($ERef_1$, ..., $ERef_p$) comportant un premier sous-ensemble PRef_1 correspondant à la première classe C1 et un deuxième sous-ensemble PRef_2 correspondant à la deuxième classe C2,
- déterminer une moyenne Moy et un écart type S des échantillons de l'ensemble PRef d'échantillons de référence,
- normaliser les valeurs de l'ensemble PRef d'échantillons de référence de façon à obtenir un ensemble PRef_N d'échantillons de référence normalisés, la valeur normalisée $Eref\_N_k$ d'un échantillon ($Eref_k$) étant égale à :

$$ERef\_N_k = \left(\frac{ERef_k - Moy}{S}\right)$$

- entrainer le modèle de classification M2 avec au moins une partie des valeurs de l'ensemble (PRef_N) de valeurs normalisées.

Après normalisation, l'ensemble PRef_N d'échantillons de référence normalisés comprend un sous-ensemble PRef_N_1 correspondant à la première classe C1 et un deuxième sous-ensemble PRef_N_2 correspondant à la deuxième classe C2. Autrement dit, les données de l'ensemble P des échantillons à classifier sont préalablement normalisées avant d'être utilisées pour entrainer le modèle de classification M2. Le modèle de classification M2 est ainsi entrainé avec les valeurs corrigées des échantillons de la première classe C1 et les valeurs corrigées des échantillons de la deuxième classe C2.

Plus précisément, l'étape visant à normaliser les valeurs de l'ensemble P d'échantillons à classifier comporte les étapes :

- déterminer la moyenne Moy et l'écart type Ect des échantillons ($Eref_1$, ..., $Eref_p$) de l'ensemble PRef d'échantillons de référence. Ce calcul intègre toutes les valeurs de l'ensemble PRef d'échantillons de référence, c'est-à-dire les éléments du premier sous-ensemble PRef_1 qui correspond à la première classe C1, et les éléments du deuxième sous-ensemble PRef_2 qui correspond à la deuxième classe C2.
- pour chaque échantillon $Eref_i$ du premier sous-ensemble PREf_1, I la valeur corrigée Eref_Ni est obtenue en soustrayant à la valeur de échantillon $Eref_i$ la valeur de la moyenne Moy déterminée, puis en divisant le résultat de la soustraction par l'écart type déterminé Ect, Cette opération est itérée pour tous les échantillons du premier sous ensemble PRef_1, qui correspond à la première classe C1.
- de même, pour chaque échantillon $ERef_j$ du deuxième sous-ensemble PREf_2, la valeur corrigée Eref_N_j est obtenue en soustrayant à la valeur de

échantillon Eref_N_j la valeur de la moyenne Moy déterminée, puis en divisant le résultat de la soustraction par l'écart type déterminé Ect. Cette opération est également itérée pour tous les échantillons du deuxième sous-ensemble PRef_2, qui correspond à la deuxième classe C2.

Ce changement de variables permet une normalisation des données, c'est-à-dire un traitement visant à rendre le processus indépendant de l'amplitude de variation des échantillons acquis. Cette étape de normalisation des données acquises avant leur utilisation par le processus d'apprentissage automatique permet d'améliorer la qualité de l'apprentissage. Le taux de mauvaise classification est ainsi réduit. Le traitement de normalisation des données est appliqué de la même manière lorsque la classification comporte plus de deux classes distinctes.

## Revendications

1. Procédé de classification de décharge partielle dans un isolant (5) d'un conducteur électrique (1) d'un appareil électrique (2) de moyenne tension ou de haute tension, le procédé étant mis en œuvre par une unité électronique de contrôle (10) et configuré pour classer une décharge partielle parmi au moins une première classe (C1) et une deuxième classe (C2) distincte de la première classe (C1),

   le procédé comportant les étapes :

   - obtenir un ensemble (P) d'échantillons ($E_1$..., $E_n$) correspondant chacun à au moins une décharge partielle, (étape 51)
   - déterminer une durée (Delta) séparant deux échantillons consécutifs de l'ensemble (P) d'échantillons correspondant chacun à au moins une décharge partielle,
   - déterminer un modèle de classification (M2) par apprentissage automatique à partir d'au moins une grandeur statistique (G) des échantillons de l'ensemble (P) obtenu, (étape 52)

   dans lequel la grandeur statistique (G) de l'ensemble (P) d'échantillons à classifier comprend la durée (Delta) séparant deux échantillons consécutifs de l'ensemble (P) d'échantillons à classifier,

   - acquérir un nouvel échantillon ($E_{n+1}$) correspondant à au moins une décharge partielle, (étape 53)
   - déterminer la classe (C1, C2) de la décharge partielle associée au nouvel échantillon acquis ($E_{n+1}$) à partir du modèle de classification (M2). (étape 54)

**2.** Procédé selon la revendication 1, dans lequel la tension dans le conducteur électrique (1) est périodique de période (T), dans lequel le nouvel échantillon acquis ($E_{n+1}$) est obtenu par intégration d'un signal vibratoire (V) pendant une fenêtre temporelle (SW) d'acquisition, et dans lequel une durée (D) de la fenêtre temporelle (SW) d'acquisition est égale à un multiple (k) de la période (T) de la tension.

**3.** Procédé selon l'une des revendications précédentes, comportant l'étape :

- calculer une fonction de distribution (D) des valeurs de chaque échantillon de l'ensemble (P) d'échantillons à classifier.

**4.** Procédé selon la revendication 3, dans lequel la grandeur statistique (G) comprend le coefficient d'asymétrie de la fonction de distribution (D) obtenue.

**5.** Procédé selon la revendication 3 ou 4, dans lequel la grandeur statistique (G) comprend le coefficient d'aplatissement de la fonction de distribution (D) obtenue.

**6.** Procédé selon l'une des revendications précédentes, comportant l'étape :

- déterminer parmi l'ensemble (P) d'échantillons ($E_1 ..., E_n$) correspondant chacun à au moins une décharge partielle une fraction d'échantillons ayant une valeur positive,

dans lequel la grandeur statistique (G) comprend la fraction d'échantillons ayant une valeur positive.

**7.** Procédé selon l'une des revendications précédentes, dans lequel la tension présente des variations périodiques, et dans lequel la grandeur statistique (G) comprend un phasage du nouvel échantillon acquis ($E_{n+1}$) par rapport aux variations périodiques de la tension.

**8.** Procédé selon l'une des revendications 1 à 7, comportant successivement les étapes :

- acquérir un ensemble (PRef) d'échantillons de référence comportant un premier sous-ensemble (PREf_1) correspondant à la première classe (C1) et un deuxième sous-ensemble (PRef_2) correspondant à la deuxième classe (C2),
- entrainer le modèle de classification (M2) avec au moins une partie de l'ensemble (PRef) d'échantillons de référence.

**9.** Procédé selon l'une des revendications 1 à 7, comportant successivement les étapes :

- acquérir un ensemble (PRef) d'échantillons de référence ($Eref_1$, ..., $ERef_p$) comportant un premier sous-ensemble (PREf_1) correspondant à la première classe (C1) et un deuxième sous-ensemble (PRef_2) correspondant à la deuxième classe (C2),
- déterminer une moyenne Moy et un écart type S des échantillons de l'ensemble (PRef) d'échantillons de référence,
- normaliser les valeurs de l'ensemble (PRef) d'échantillons de référence de façon à obtenir un ensemble (PRef_N) d'échantillons de référence normalisés, la valeur normalisée $Eref\_N_k$ d'un échantillon de référence $Eref_k$ étant égale à :

$$Eref\_N_k = \left( \frac{Eref_k - Moy}{S} \right)$$

- entrainer le modèle de classification (M2) avec au moins une partie des valeurs de l'ensemble (PRef_N) d'échantillons de référence normalisés.

**10.** Appareil électrique (2) de moyenne tension ou de haute tension, l'appareil électrique (2) comportant :

- un conducteur électrique (1),
- un capteur (3) configuré pour fournir un signal vibratoire (V) associé à un isolant (5) du conducteur électrique (1),
- une unité électronique de contrôle (10) configurée pour mettre en œuvre le procédé de classification de décharge partielle selon l'une des revendications précédentes.

**11.** Appareil électrique (2) selon la revendication précédente, dans lequel le capteur (3) est configuré pour fournir un signal représentatif d'une vibration de l'isolant (5) du conducteur électrique (1).

**Patentansprüche**

**1.** Verfahren zur Klassifikation einer Teilentladung in einem Isolator (5) eines elektrischen Leiters (1) eines elektrischen Mittel- oder Hochspannungsgeräts (2), wobei das Verfahren von einer elektronischen Steuerungseinheit (10) durchgeführt wird und dazu ausgestaltet ist, eine Teilentladung in mindestens eine erste Klasse (C1) und eine zweite Klasse (C2), die von der ersten Klasse (C1) verschieden ist, zu klassifizieren,

das Verfahren umfassend die Schritte:

- Erhalten einer Menge (P) von Abtastungen $(E_1..., E_n)$, die jeweils mindestens einer Teilentladung entsprechen (Schritt 51),
- Bestimmen einer Dauer (Delta), die zwei aufeinander folgende Abtastungen der Menge (P) von Abtastungen trennt, die jeweils mindestens einer Teilentladung entsprechen,
- Bestimmen eines Klassifikationsmodells (M2) durch maschinelles Lernen ausgehend von mindestens einer statistischen Größe (G) der Abtastungen der erhaltenen Menge (P) (Schritt 52),

wobei die statistische Größe (G) der Menge (P) von zu klassifizierenden Abtastungen die Dauer (Delta) umfasst, die zwei aufeinander folgende Abtastungen der Menge (P) von zu klassifizierenden Abtastungen trennt,

- Erfassen einer neuen Abtastung $(E_{n+1})$, die mindestens einer Teilentladung entspricht (Schritt 53),
- Bestimmen der Klasse (C1, C2) der Teilentladung, die der erfassten neuen Abtastung $(E_{n+1})$ zugeordnet ist, ausgehend von dem Klassifikationsmodell (M2) (Schritt 54).

2. Verfahren nach Anspruch 1, wobei die Spannung in dem elektrischen Leiter (1) mit der Periode (T) periodisch ist, wobei die erfasste neue Abtastung $(E_{n+1})$ durch Integration eines Schwingungssignals (V) während eines Erfassungszeitfensters (SW) erhalten wird und wobei eine Dauer (D) des Erfassungszeitfensters (SW) gleich einem Vielfachen (k) der Periode (T) der Spannung ist.

3. Verfahren nach einem der vorhergehenden Ansprüche, umfassend den Schritt:

- Berechnen einer Verteilungsfunktion (D) der Werte jeder Abtastung der Menge (P) von zu klassifizierenden Abtastungen.

4. Verfahren nach Anspruch 3,
wobei die statistische Größe (G) den Asymmetriekoeffizienten der erhaltenen Verteilungsfunktion (D) umfasst.

5. Verfahren nach Anspruch 3 oder 4,
wobei die statistische Größe (G) den Wölbungskoeffizienten der erhaltenen Verteilungsfunktion (D) umfasst.

6. Verfahren nach einem der vorhergehenden Ansprüche, umfassend den Schritt:

- Bestimmen, unter der Menge (P) von Abtastungen $(E_1..., E_n)$, die jeweils mindestens einer Teilentladung entsprechen, eines Anteils von Abtastungen, die einen positiven Wert haben,

wobei die statistische Größe (G) den Anteil von Abtastungen umfasst, die einen positiven Wert haben.

7. Verfahren nach einem der vorhergehenden Ansprüche, wobei die Spannung periodische Schwankungen aufweist und wobei die statistische Größe (G) eine Phasierung der erfassten neuen Abtastung $(E_{n+1})$ in Bezug auf die periodischen Schwankungen der Spannung umfasst.

8. Verfahren nach einem der Ansprüche 1 bis 7, umfassend nacheinander die Schritte:

- Erfassen einer Menge (PRef) von Referenzabtastungen, umfassend eine erste Teilmenge (PREf_1), die der ersten Klasse (C1) entspricht, und eine zweite Teilmenge (PRef_2), die der zweiten Klasse (C2) entspricht,
- Trainieren des Klassifikationsmodells (M2) mit mindestens einem Teil der Menge (PRef) von Referenzabtastungen.

9. Verfahren nach einem der Ansprüche 1 bis 7, umfassend nacheinander die Schritte:

- Erfassen einer Menge (PRef) von Referenzabtastungen $(Eref_1, ..., ERef_p)$, umfassend eine erste Teilmenge (PREf_1), die der ersten Klasse (C1) entspricht, und eine zweite Teilmenge (PRef_2), die der zweiten Klasse (C2) entspricht,
- Bestimmen eines Mittelwerts Moy und einer Standardabweichung S der Abtastungen der Menge (PRef) von Referenzabtastungen,
- Standardisieren der Werte der Menge (PRef) von Referenzabtastungen, so dass eine Menge (PRef_N) von standardisierten Referenzabtastungen erhalten wird, wobei der standardisierte Wert Eref_Nk einer Referenzabtastung $Eref_k$ beträgt:

$$Eref\_N_k = \left(\frac{Eref_k - Moy}{S}\right)$$

- Trainieren des Klassifikationsmodells (M2) mit mindestens einem Teil der Werte der Menge (PRef_N) von standardisierten Referenzabtastungen.

**10.** Elektrisches Mittelspannungs- oder Hochspannungsgerät (2), das elektrische Gerät (2) umfassend:

- einen elektrischen Leiter (1),
- einen Sensor (3), der dazu ausgestaltet ist, ein Schwingungssignal (V) bereitzustellen, das einem Isolator (5) des elektrischen Leiters (1) zugeordnet ist,
- eine elektronische Steuerungseinheit (10), die dazu ausgestaltet ist, das Verfahren zur Klassifikation einer Teilentladung nach einem der vorhergehenden Ansprüche durchzuführen.

**11.** Elektrisches Gerät (2) nach dem vorhergehenden Anspruch, wobei der Sensor (3) dazu ausgestaltet ist, ein Signal bereitzustellen, das für eine Schwingung des Isolators (5) des elektrischen Leiters (1) repräsentativ ist.

**Claims**

**1.** Method for classifying a partial discharge in an insulator (5) of an electrical conductor (1) of a medium voltage or high voltage electrical device (2), the method being implemented in an electronic control unit (10) and being configured to classify a partial discharge from between at least a first class (C1) and a second class (C2) distinct from the first class (C1),

the method comprising the steps:

- obtain a set (P) of samples ($E_1$..., $E_n$) each corresponding to at least one partial discharge, (step 51)
- determine a duration (Delta) separating two consecutive samples of the set (P) of samples each corresponding to at least one partial discharge,
- determine a classification model (M2) by automatic learning based on at least one statistical quantity (G) of the samples of the set (P) obtained (step 52),

in which the statistical quantity (G) of the set (P) of samples to be classified comprises the duration (Delta) separating two consecutive samples of the set (P) of samples to be classified,

- acquire a new sample ($E_{n+1}$) corresponding to at least one partial discharge, (step 53)
- determine the class (C1, C2) of the partial discharge associated with the new sample acquired ($E_{n+1}$) based on the classification model (M2). (step 54)

**2.** Method according to Claim 1, in which the voltage in the electrical conductor (1) is periodic with a period (T), in which the new sample acquired ($E_{n+1}$) is obtained by integration of an oscillating signal (V) over an acquisition time window (SW), and in which a duration (D) of the acquisition time window (SW) is equal to a multiple (k) of the period (T) of the voltage.

**3.** Method according to one of the preceding claims, comprising the step:

- calculate a distribution function (D) for the values of each sample of the set (P) of samples to be classified.

**4.** Method according to Claim 3, in which the statistical quantity (G) comprises the coefficient of asymmetry of the distribution function (D) obtained.

**5.** Method according to either of Claims 3 and 4, in which the statistical quantity (G) comprises the coefficient of flattening of the distribution function (D) obtained.

**6.** Method according to one of the preceding claims, comprising the step:

- determine from amongst the set (P) of samples ($E_1$..., $E_n$), each corresponding to at least one partial discharge, a fraction of samples having a positive value,

in which the statistical quantity (G) comprises the fraction of samples having a positive value.

**7.** Method according to one of the preceding claims, in which the voltage exhibits periodic variations, and in which the statistical quantity (G) comprises a phasing of the new sample acquired ($E_{n+1}$) with respect to the periodic variations of the voltage.

**8.** Method according to one of Claims 1 to 7, comprising successively the steps:

- acquire a set (PRef) of reference samples comprising a first sub-set (PREf_1) corresponding to the first class (C1) and a second sub-set (PRef_2) corresponding to the second class (C2),
- drive the classification model (M2) with at least a part of the set (PRef) of reference samples.

**9.** Method according to one of Claims 1 to 7, comprising successively the steps:

- acquire a set (PRef) of reference samples ($Eref_1$, ..., $ERef_p$) comprising a first sub-set

**EP 4 170 363 B1**

(PREf_1) corresponding to the first class (C1) and a second sub-set (PRef_2) corresponding to the second class (C2),

- determine a mean Moy and a standard deviation S for the samples of the set (PRef) of reference samples,

- normalize the values of the set (PRef) of reference samples so as to obtain a set (PRef_N) of normalized reference samples, the normalized value $Eref\_N_k$ of a sample $Eref_k$ being equal to:

$$Eref\_N_k = \left( \frac{Eref_k - Moy}{S} \right)$$

- drive the classification model (M2) with at least a part of the values of the set (PRef_N) of normalized values.

10. Medium voltage or high voltage electrical device (2), the electrical device (2) comprising:

- an electrical conductor (1),
- a sensor (3) configured for supplying an oscillating signal (V) associated with an insulator (5) of the electrical conductor (1),
- an electronic control unit (10) configured for implementing the method for classifying a partial discharge according to one of the preceding claims.

11. Electrical device (2) according to the preceding Claim, in which the sensor (3) is configured for supplying a signal representative of a vibration of the insulator (5) of the electrical conductor (1).

[Fig. 1]

FIG. 1

[Fig. 2]

FIG. 2

[Fig. 3]

FIG. 3

[Fig. 4]

FIG. 4

[Fig. 5]

(A)　　　　　　　　　　　(B)　　　　　　　　　　　(C)

FIG. 5

[Fig. 6]

(A)　　　　　　　　　　　(B)　　　　　　　　　　　(C)

FIG. 6

[Fig. 7]

FIG. 7

## EP 4 170 363 B1